(19) Europäisches Patentamt
European Patent Office
Office européen des brevets

(11) **EP 4 314 788 B1**

(12) **EUROPÄISCHE PATENTSCHRIFT**

(45) Veröffentlichungstag und Bekanntmachung des Hinweises auf die Patenterteilung:
**07.05.2025 Patentblatt 2025/19**

(21) Anmeldenummer: **22718619.4**

(22) Anmeldetag: **25.03.2022**

(51) Internationale Patentklassifikation (IPC):
**G01N 24/00** (2006.01)   **G01R 33/26** (2006.01)
**G01R 33/32** (2006.01)   **G01R 33/381** (2006.01)

(52) Gemeinsame Patentklassifikation (CPC):
**G01N 24/006; G01R 33/26; G01R 33/323;**
G01R 33/381

(86) Internationale Anmeldenummer:
**PCT/EP2022/057882**

(87) Internationale Veröffentlichungsnummer:
**WO 2022/207480 (06.10.2022 Gazette 2022/40)**

(54) **SENSORVORRICHTUNG ZUR MAGNETFELDMESSUNG MITTELS OPTISCHER MAGNETRESONANZMESSUNG**

SENSOR DEVICE FOR MAGNETIC FIELD MEASUREMENT BY MEANS OF OPTICAL MAGNETIC RESONANCE MEASUREMENT

CAPTEUR POUR LA MESURE D'UN CHAMP MAGNÉTIQUE AU MOYEN D'UNE MESURE DE RÉSONANCE MAGNÉTIQUE OPTIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **29.03.2021 DE 102021203129**

(43) Veröffentlichungstag der Anmeldung:
**07.02.2024 Patentblatt 2024/06**

(73) Patentinhaber: **Robert Bosch GmbH**
**70442 Stuttgart (DE)**

(72) Erfinder: **FUCHS, Tino**
**72076 Tuebingen (DE)**

(56) Entgegenhaltungen:
**CN-A- 108 983 121    DE-A1- 102018 214 617**

- **DOUDOU ZHENG ET AL: "A hand-held magnetometer based on an ensemble of nitrogen-vacancy centers in diamond", JOURNAL OF PHYSICS D: APPLIED PHYSICS, INSTITUTE OF PHYSICS PUBLISHING, BRISTOL, GB, vol. 53, no. 15, 11 February 2020 (2020-02-11), pages 155004, XP020352447, ISSN: 0022-3727, [retrieved on 20200211], DOI: 10.1088/1361-6463/AB6AF2**
- **STÜRNER FELIX M ET AL: "Compact integrated magnetometer based on nitrogen-vacancy centres in diamond", DIAMOND AND RELATED MATERIALS, vol. 93, 17 January 2019 (2019-01-17), pages 59 - 65, XP085642093, ISSN: 0925-9635, DOI: 10.1016/J.DIAMOND.2019.01.008**
- **STÜRNER FELIX M. ET AL: "Integrated and Portable Magnetometer Based on Nitrogen-Vacancy Ensembles in Diamond", ADVANCED QUANTUM TECHNOLOGIES, vol. 4, no. 4, 10 February 2021 (2021-02-10), pages 2000111, XP055936395, ISSN: 2511-9044, Retrieved from the Internet <URL:https://onlinelibrary.wiley.com/doi/full-xml/10.1002/qute.202000111> [retrieved on 20220628], DOI: 10.1002/qute.202000111**

• CHEN GUO-BIN ET AL: "Vectorial Near-Field Characterization of Microwave Device by Using Micro Diamond Based on Tapered Fiber", IEEE JOURNAL OF QUANTUM ELECTRONICS, IEEE, USA, vol. 56, no. 3, 27 April 2020 (2020-04-27), pages 1 - 6, XP011787316, ISSN: 0018-9197, [retrieved on 20200508], DOI: 10.1109/ JQE.2020.2990684

**Beschreibung**

Die vorliegende Erfindung betrifft eine Sensorvorrichtung zur Magnetfeldmessung mittels optischer Magnetresonanzmessung (ODMR), umfassend einen Diamanten mit einer Vielzahl von Farbzentren, insbesondere Stickstoff-Fehlstellen, einen Laseremitter, einen ersten Photodetektor und eine Leiterplatte, wobei der Laseremitter zur Fluoreszenzanregung der Farbzentren in dem Diamanten ausgebildet ist, wobei der erste Photodetektor zum Empfangen einer Fluoreszenz-Strahlung der Farbzentren des Diamanten ausgebildet ist.

Stand der Technik

Negativ geladene Stickstoff-Fehlstellen-Zentren, d.h. ein Farbzentrum bestehend aus einem substituierenden Stickstoff-Atom im Diamantgitter und direkt im Gitter benachbarter Fehlstelle, in einem Diamanten können zu hochempfindlichen Messungen von Magnetfeldern, elektrischen Feldern, mechanischen Spannungen und Temperaturen genutzt werden. Derartige Quantentechnologien bieten gegenüber klassischen Sensorprinzipien entscheidende Vorteile. Die Vorteile bestehen unter anderem in ultrahohen Empfindlichkeiten, der Möglichkeit der Vektormagnetometrie (Richtungsbestimmung des Magnetfeldes) und in einem großen linearen Messbereich (Zeeman-Effekt). Ferner tritt keine Degradation auf, da Farbzentren stabil sind bzw. nicht ausbleichen und die Messung auf quantenmechanischen Zuständen beruht. Um einen auf Stickstoff-Fehlstellen-Zentren basierten Sensor auszulesen, wird die magnetische Resonanz des Triplets des Grundzustandes optisch detektiert (ODMR - optically detected magnetic resonance). Dazu muss das Stickstoff-Fehlstellen-Zentrum mit grünem Licht angeregt werden. Das rotverschobene Fluoreszenzlicht zeigt dabei einen charakteristischen Dip bei der energetischen Lage der Elektronenspinresonanz. Die Lage ist aufgrund des Zeeman-Effekts linear abhängig vom magnetischen Feld am Ort des Stickstoff-Fehlstellen-Zentrums. Da das Stickstoff-Fehlstellen-Zentrum im einkristallinen Diamant vier Möglichkeiten besitzt, sich im Kristallgitter auszurichten, kommt es bei Anwesenheit eines gerichteten Magnetfelds dazu, dass die im Kristall vorhandenen Stickstoff-Fehlstellen-Zentren je nach Lage im Kristall unterschiedlich stark auf das äußere Magnetfeld reagieren. Das heißt, dass die Projektion des Magnetfeldes auf die Stickstoff-Fehlstellen-Achse unterschiedlich groß ist. Dadurch können im Maximalfall vier einander zugehörige Paare von Fluoreszenzminima im Spektrum auftauchen, aus deren Form und Lage zueinander Betrag und Richtung des Magnetfeldes eindeutig bestimmbar sind.

Um bereits bei schwachen, äußeren Magnetfeldern eine Vektorinformation erlangen zu können, muss durch geeignete technische Maßnahmen dafür gesorgt werden, dass im ODMR-Spektrum auch ohne ein von außen auf den Sensor einwirkendes Magnetfeld die Beiträge aller vier möglichen Stickstoff-Fehlstellen-Orientierungen im Diamantkristall unterschieden werden können. Dies kann durch ein statisches Bias-Magnetfeld erfolgen, welches innerhalb des Sensors durch entsprechende technische Maßnahmen bereitgestellt wird. Das Bias-Magnetfeld muss innerhalb des sensitiven Diamantvolumens eine möglichst homogene Feldstärke aufweisen, da Inhomogenitäten des Bias-Magnetfeldes die Empfindlichkeit des Sensors beeinträchtigen. Die Stärke des Bias-Magnetfeldes sollte zu effektiven Aufspaltungen der vier Stickstoff-Fehlstellen-Orientierungen zwischen 100 μT und 10 mT, idealerweise ca. 1 mT, betragen. Das Bias-Feld darf im Bereich des Diamantvolumens um nicht mehr als 1 ‰ vom Sollwert abweichen. Die Erzeugung des Bias-Feldes kann durch Permanentmagnete oder durch stromdurchflossene Spulen erfolgen.

Um eine Empfindlichkeit von $< 1 \, \mathrm{pT}/\sqrt{Hz}$ erzielen zu können, ist es erforderlich, die Stickstoff-Fehlstellen im Diamanten mit ca. 1 % der bei 100 kW/cm$^2$ liegenden Sättigungsleistungsdichte optisch zu pumpen. Um derartige Intensitäten zu erreichen, werden Laseremitter verwendet.

Bei den bekannten Sensorvorrichtungen zur Magnetfeldmessung mittels optischer Magnetresonanzmessung ist dieser Laseremitter eine eigenständige Komponente, und das Licht wird entweder per Freistrahloptik oder durch eine optische Faser zum Diamanten geleitet. Daher benötigen bekannte Sensorvorrichtungen zur Magnetfeldmessung einen großen Bauraum, wodurch die möglichen Anwendungsfelder eingeschränkt sind. Zudem bringt der separate Laseremitter einen signifikanten Beitrag zu den Herstellungskosten, sodass Anwendungsfälle mit starkem Kostendruck nicht bedient werden können.

Aus der DE 10 2018 214 617 A1 der Anmelderin ist eine Sensoreinrichtung mit einem Kristallkörper, insbesondere einem Diamanten, mit einer Anzahl von Farbzentren, insbesondere von Stickstoff-Fehlstellen, einer Lichtquelle zum Bestrahlen des Kristallkörpers mit sichtbarem Licht, einer Hochfrequenzeinrichtung zum Bestrahlen des Kristallkörpers mit Mikrowellen, und einem Photodetektor bekannt. Der Photodetektor ist eingerichtet zum Detektieren von Fluoreszenzlicht, welches aufgrund der Bestrahlung des Kristallkörpers durch das sichtbare Licht und die Mikrowellen erzeugt wird, wobei die Sensoreinrichtung eine zwischen dem Kristallkörper und dem Photodetektor angeordnete Gradientenbrechungsindexlinse oder einen zwischen dem Kristallkörper und dem Photodetektor angeordneten Lichtleiter, und/oder einen die Lichtquelle für sichtbares Licht wenigstens teilweise umgebenden Spiegel und/oder wenigstens eine einen Teil einer Oberfläche des Kristallkörpers bedeckende Filterschicht aufweist.

Eine Sensorvorrichtung gemäß Oberbegriff des Anspruchs 1 geht aus Stürner, Felix M. et al.: "Compact integrated magnetometer based on nitrogen-vacancy centres in diamond", Diamond and Related Materials, Bd. 93, 17.Januar 2019, Seiten 59 - 65 hervor. Eine weitere solche Sensorvorrichtung ist aus Stürner Felix M. et al.: "Integrated and Portable Magnetometer Based on Nitrogen-Vacancy Ensembles in Diamond", Advanced Quantum Technilogies, Bd. 4, Nr.4, 10.Februar 2021, Seite 2000111 bekannt. Die hierin offenbarte Sensorvorrichtung weist einen Sensorkopf und zwei Photodioden auf, wobei Helmholtz-Spulen zur spektralen Aufspaltung der vier NV-Orientierungen verwendet werden.

Offenbarung der Erfindung

Der vorliegenden Erfindung liegt die Aufgabe zugrunde, eine Sensorvorrichtung zur Magnetfeldmessung mittels optischer Magnetresonanzmessung bereitzustellen, welche gegenüber bekannten Vorrichtungen eine verringerte Baugröße und reduzierte Herstellungskosten aufweist.

Zur Lösung der der Erfindung zugrundeliegenden Aufgabe wird eine Sensorvorrichtung zur Magnetfeldmessung mittels optischer Magnetresonanzmessung (ODMR) gemäss Anspruch 1, umfassend einen Diamanten mit einer Vielzahl von Farbzentren, insbesondere Stickstoff-Fehlstellen, einen Laseremitter, einen ersten Photodetektor und eine Leiterplatte vorgeschlagen, wobei der Laseremitter zur Fluoreszenzanregung der Farbzentren in dem Diamanten ausgebildet ist, wobei der erste Photodetektor zum Empfangen einer Fluoreszenz-Strahlung der Farbzentren des Diamanten ausgebildet ist, wobei vorgesehen ist, dass die Leiterplatte mehrere Schichten umfassend mindestens eine innenliegende Schicht aufweist, dass der Laseremitter auf einer Oberseite der Leiterplatte angeordnet ist, dass der erste Photodetektor auf einer Unterseite der Leiterplatte angeordnet ist, dass der Diamant im Inneren der Leiterplatte in der Erstreckungsebene der mindestens einen innenliegenden Schicht angeordnet ist, und dass mindestens eine der Schichten stromführende Strukturen aufweist, welche ausgebildet sind, ein senkrecht zu den Schichten der Leiterplatte ausgerichtetes, homogenes und den Diamanten durchsetzendes Magnetfeld zu erzeugen.

Im Rahmen der vorliegenden Erfindung werden die Begriffe "Stickstoff-Fehlstelle", "Stickstoff-Fehlstellen-Zentrum" und "NV-Zentrum" synonym verwendet und können gegeneinander ausgetauscht werden.

Die Farbzentren, insbesondere die Stickstoff-Fehlstellen-Zentren und/oder die NV-Zentren, sind bevorzugt negativ geladen.

Das physikalische Prinzip der Magnetfeldmessung mittels optischer Magnetresonanzmessung (ODMR), für welches die erfindungsgemäße Sensorvorrichtung geeignet ist, ist dem Fachmann bekannt und wird an dieser Stelle nicht näher erläutert.

Die Leiterplatte der erfindungsgemäßen Sensorvorrichtung weist mehrere Schichten auf. Das heißt insbesondere, dass die Leiterplatte aus mehreren Schichten eines Substrats ausgebildet ist, wobei jede Schicht stromleitende Strukturen aufweisen kann. Die Erstreckungsebenen der Schichten liegen parallel zueinander, und die Schichten sind unbeabstandet zueinander in direktem physischen Kontakt angeordnet und miteinander verbunden.

Die Leiterplatte weist mindestens eine innenliegende Schicht auf. Demzufolge weist die Leiterplatte mindestens drei Schichten auf. In der Erstreckungsebene der mindestens einen innenliegenden Schicht ist der Diamant der Sensorvorrichtung angeordnet. Hierfür kann in der mindestens einen innenliegenden Schicht eine entsprechende Aussparung vorgesehen sein. In der Richtung senkrecht zu der Erstreckungsebene der innenliegenden Schicht kann der Diamant über die innenliegende Schicht hinausragen, sodass der Diamant zumindest teilweise auch in weiteren innenliegenden Schichten der Leiterplatte, soweit diese vorhanden sind, angeordnet ist. Da der Diamant im Inneren der Leiterplatte in der Erstreckungsebene der mindestens einen innenliegenden Schicht angeordnet ist, umfasst die innenliegende Schicht den Diamanten.

Erfindungsgemäß ist nun vorgesehen, dass mindestens eine der Schichten stromführende Strukturen aufweist, welche ausgebildet sind, ein senkrecht zu den Schichten der Leiterplatte ausgerichtetes, homogenes und den Diamanten durchsetzendes Magnetfeld zu erzeugen.

Das homogene und den Diamanten durchsetzende Magnetfeld kann dabei ein Bias-Magnetfeld sein, mit welchem während der Magnetresonanzmessung auch ohne ein von außen auf die Sensorvorrichtung einwirkendes Magnetfeld die Beiträge der möglichen Spinnorientierungen der Stickstoff-Fehlstellen im Diamanten unterschieden werden können.

Besonders vorteilhaft an der erfindungsgemäßen Sensorvorrichtung ist, dass durch die Anordnung des Diamanten im Inneren der Leiterplatte und die im Inneren der Leiterplatte angeordneten stromführenden Strukturen eine besonders kompakte Sensorvorrichtung zur Magnetfeldmessung bereitgestellt werden kann. Ferner sind die Herstellungskosten reduziert.

Die stromführenden Strukturen können dabei als Spule oder als Stromschleifen ausgebildet sein. Das heißt, dass die stromführenden Strukturen bei einer Aufsicht auf die Leiterplatte senkrecht zu den Erstreckungsebenen der Schichten kreisförmig oder ringförmig ausgebildet sein können. Ferner kann vorgesehen sein, dass die stromführenden Strukturen den in der innenliegenden Schicht angeordneten Diamanten umschließen.

Bei bekannten Vorrichtungen wird das Bias-Magnetfeld beispielsweise mit einem Helmholtz-Spulenpaar erzeugt, welches außerhalb der Sensorvorrichtungen angeordnet ist. Bei der erfindungsgemäßen Sensorvorrichtung kann auf die Verwendung eines externen Helmholtz-Spulenpaars verzichtet werden. Die Erzeugung des Bias-Magnetfelds wird von den in die Leiterplatte integrierten stromführenden Strukturen übernommen.

Mit weiterem Vorteil kann vorgesehen sein, dass der Laseremitter eine Laserdiode ist, und/oder dass der Photodetektor eine Fotodiode ist. Laserdioden können die benötigte Intensität für die optische Anregung der Stickstoff-Fehlstellenzentren des Diamanten bereitstellen. Darüber hinaus sind Laserdioden und und/oder Photodioden klein und kostengünstig.

Der Laseremitter ist bevorzugt ausgebildet, optisches Licht im grünen Bereich bevorzugt zwischen 520 nm bis 530 nm zu emittieren.

Mit weiterem Vorteil kann vorgesehen sein, dass mehrere der Schichten stromführende Strukturen zur Erzeugung des homogenen Magnetfeldes aufweisen, wobei die Schichten bevorzugt oberhalb und unterhalb der den Diamanten umfassenden Schicht angeordnet sind.

In einer besonderen Ausführungsform ist oberhalb der den Diamanten umfassenden Schicht mindestens eine weitere Schicht vorgesehen, welche eine, beispielsweise als Stromschleife oder als Spule ausgebildete, stromführende Struktur umfasst. Ferner ist bevorzugt unterhalb der den Diamanten umfassenden Schicht eine weitere Schicht vorgesehen, welche eine, beispielsweise als Stromschleife oder als Spule ausgebildete, stromführende Struktur umfasst. Oberhalb und unterhalb der den Diamanten umfassenden Schicht können auch mehrere Schichten mit stromführende Strukturen angeordnet sein.

Die Begriffe oberhalb und unterhalb beziehen sich auf eine Richtung senkrecht zu den Erstreckungsebenen der Schichten, wobei oberhalb der den Diamanten umfassenden Schicht angeordnete Schichten näher an der Oberseite und dem auf der Oberseite angeordneten Laseremitter sind und unterhalb der den Diamanten umfassenden Schicht angeordnete Schichten näher an der Unterseite und dem an der der Unterseite angeordneten Photodetektor sind.

Bevorzugt kann vorgesehen sein, dass die Emissionsrichtung des Laseremitters parallel zu der Oberseite der Leiterplatte ausgerichtet ist, und dass an einer ersten Lichtaustrittsseite des Laseremitters ein erstes optisches Element angeordnet ist, welches ausgebildet ist, aus der ersten Lichtaustrittseite austretendes Laserlicht, bevorzugt um 90°, umzulenken, sodass das Laserlicht auf den Diamanten trifft.

Das erste optische Element ist somit dazu ausgebildet, den aus der ersten Lichtaustrittsseite des Laseremitters austretenden Laserstrahl, welcher parallel zur Oberseite der Leiterplatte den Laseremitter verlässt, ins Innere der Leiterplatte, bevorzugt um 90°, umzulenken, sodass das Laserlicht auf den dort angeordneten Diamanten trifft. Der Laseremitter kann daher bündig und direkt auf der Oberseite der Leiterplatte befestigt werden, wodurch Bauraum eingespart wird.

Bevorzugt ist vorgesehen, dass das erste optische Element in einem unmittelbaren und direkten physischen Kontakt mit der ersten Lichtaustrittsseite des Laseremitters angeordnet ist.

Bevorzugt ist vorgesehen, dass das erste optische Element ein Spiegel oder ein Prisma ist.

Weiter bevorzugt ist ein zweiter Photodetektor vorgesehen, wobei der zweite Photodetektor auf der Unterseite der Leiterplatte angeordnet ist, und dass an einer der ersten Lichtaustrittsseite des Laseremitters gegenüberliegenden zweiten Lichtaustrittsseite ein zweites optisches Element, bevorzugt ein Spiegel oder ein Prisma, angeordnet ist, welches ausgebildet ist, aus der zweiten Lichtaustrittseite austretendes Laserlicht, bevorzugt um 90°, umzulenken, sodass das Laserlicht auf den zweiten Photodetektor trifft.

Mit dem aus der zweiten Lichtaustrittsseite emittierten und auf den zweiten Photodetektor gelenkten Laserlicht kann ein Referenzlaserstrahl aufgebaut und mit dem zweiten Photodetektor gemessen werden. Der Referenzlaserstrahl dient dazu, Fluktuationen in der Laserlichtleistung zu korrigieren.

Damit das von dem zweiten optischen Element umgelenkte Laserlicht ausgehend von der Oberseite der Leiterplatte den an der Unterseite der Leiterplatte angeordneten zweiten Photodetektor erreicht, kann eine die Leiterplatte von der Oberseite zur Unterseite durchdringende Apertur oder Öffnung vorgesehen sein. Gegebenenfalls kann die Öffnung oder Apertur mit einem lichtleitenden Medium ausgefüllt sein.

Entsprechend kann, damit das von dem ersten optischen Element umgelenkte Laserlicht ausgehend von der Oberseite der Leiterplatte den im Inneren der Leiterplatte angeordneten Diamanten erreicht, eine die Leiterplatte von der Oberseite bis zum Diamanten durchdringende Apertur oder Öffnung vorgesehen sein. Gegebenenfalls kann die Öffnung oder Apertur mit einem lichtleitenden Medium ausgefüllt sein. Zudem kann eine weitere von dem Diamanten bis zu der Unterseite verlaufende Apertur oder Öffnung vorgesehen sein, damit die Fluoreszenz-Strahlung vom Diamanten den ersten Photodetektor erreichen kann.

Bevorzugt ist vorgesehen, dass von dem ersten optisches Element und/oder von dem zweiten optischen Element umgelenktes Laserlicht in einer Richtung senkrecht zu den Schichten durch die Leiterplatte läuft.

Bevorzugt kann vorgesehen sein, dass zwischen dem ersten optischen Element und dem Diamanten ein erster optisch transparenter Körper, bevorzugt ein Glasblock, angeordnet ist, sodass von dem ersten optischen Element umgelenktes Licht durch den ersten optisch transparenten Körper läuft und auf den Diamanten trifft.

Das von dem ersten optischen Element umgelenkte Laserlicht tritt aus dem ersten optischen Element aus und in den ersten optisch transparenten Körper ein. Durch den optisch transparenten Körper läuft das Licht dann bis zu dem Diamanten, um diesen optisch anzuregen. Der optisch transparente Körper kann dafür in einer entsprechenden, oberhalb des Diamanten in der Leiterplatte befindlichen Apertur oder Öffnung angeordnet sein.

Besonders bevorzugt befindet sich der erste optisch transparente Körper unbeabstandet und in direktem physischen Kontakt mit der Austrittsseite des ersten optischen Elements. Weiter bevorzugt befindet sich der unterhalb des ersten transparenten Körpers angeordnete Diamant unbeabstandet und in einem direkten physischen Kontakt mit einer Unterseite des ersten optisch transparenten Körpers.

Bevorzugt weist der Diamant auf einer Oberseite, bevorzugt der dem ersten optischen transparenten Körper zugewandten Seite, eine optische Beschichtung auf, insbesondere einen Rotreflektor, welcher dafür sorgt, dass grünes Anregungslicht nahezu vollständig transmittiert wird, während rotes Fluoreszenzlicht der Farbzentren mit Wellenlängen größer als etwa 700 nm nahezu vollständig reflektiert wird. Ferner bevorzugt weist der Diamant auf einer Unterseite eine optische Beschichtung, insbesondere einen Grünreflektor, auf, welcher dafür sorgt, dass rotes Fluoreszenzlicht mit Wellenlängen von größer als 700 nm nahezu vollständig transmittiert werden, während grünes Anregungslicht des Laseremitters nahezu vollständig reflektiert wird.

Mit weiterem Vorteil ist vorgesehen, dass zwischen dem Diamanten und dem ersten Photodetektor ein zweiter optisch transparenter Körper, insbesondere ein Glasblock, angeordnet ist, dass auf einer Oberseite des zweiten optisch transparenten Körpers metallische Leiterbahnen angeordnet sind, wobei eine Schicht der Leiterplatte Leitungen für die Spannungsversorgung der metallischen Leiterbahnen aufweist.

Unterhalb des Diamanten, das heißt der Unterseite der Leiterplatte näherliegend, ist erfindungsgemäss ein zweiter optisch transparenter Körper angeordnet sein, welcher weiter bevorzugt in direktem physischen Kontakt und unbeabstandet an dem Diamanten angeordnet ist. Mit anderen Worten umfasst mindestens eine der Schichten der Leiterplatte unterhalb der den Diamanten umfassenden Schicht den zweiten optisch transparenten Körper. Der zweite optisch transparente Körper weist auf einer Oberseite, das heißt der dem Diamanten zugewandten Seite, metallische Leiterbahnen oder eine metallische Beschichtung auf. Die Leiterbahnen können mit Breiten und Abständen von wenigen Mikrometern aufgebracht sein. Die den zweiten optisch transparenten Körper umfassende Schicht der Leiterplatte oder eine angrenzende Schicht weist ferner Leitungen für die Spannungsversorgung der metallischen Leiterbahnen des zweiten optisch transparenten Körpers auf. Durch Anlegen einer Wechselspannung an die Leitungen der entsprechenden Schicht können die metallischen Leiterbahnen auf dem zweiten optisch transparenten Körper mit Wechselstrom versorgt werden. Dadurch wird ein Mikrowellenmagnetfeld im Diamanten erzeugt, das parallel zur Oberseite der Leiterplatte gerichtet ist. Besonders bevorzugt ist hierfür eine Mikrowellenfrequenz von etwa 2,87 GHz vorgesehen.

Der zweite optisch transparente Körper kann dabei in der Erstreckungsebene größer ausgebildet sein als der Diamant.

Der zweite optisch transparente Körper steht bevorzugt in direktem und unbeabstandetem physischen Kontakt mit dem Diamanten.

Bevorzugt ist vorgesehen, dass zwischen dem zweiten optisch transparenten Körper und dem ersten Photodetektor ein dritter optisch transparenter Körper angeordnet ist.

Der dritte optisch transparente Körper steht bevorzugt in direktem physischen Kontakt mit der Unterseite des zweiten optisch transparenten Körpers. Ferner steht der dritte optisch transparente Körper bevorzugt in direktem physischen Kontakt mit der Oberseite des ersten Photodetektors.

Aus dem Diamanten austretendes Fluoreszenzlicht läuft durch den zweiten optisch transparenten Körper und durch den dritten optisch transparenten Körper zu dem ersten Photodetektor. Innerhalb der Leiterplatte können Aperturen, Aussparungen oder Öffnungen für den ersten, zweiten und dritten optisch transparenten Körper vorgesehen sein.

Ganz besonders bevorzugt stehen sämtliche optischen Elemente, das heißt der Laseremitter, das erste optische Element, der erste optisch transparente Körper, der Diamant, der zweite optisch transparente Körper, der dritte optisch transparente Körper und der Photodetektor in dieser Reihenfolge miteinander in direktem physischen Kontakt. Es wird somit für eine optimale Strahlführung des Lasers gesorgt, und der Bauraum für die Sensorvorrichtung wird verringert.

Mit weiterem Vorteil kann vorgesehen sein, dass zwischen dem zweiten optischen Element und dem zweiten Photodetektor ein vierter optisch transparenter Körper, bevorzugt ein Glasblock, angeordnet ist.

Der vierte optisch transparente Körper steht weiter bevorzugt in direktem physischen Kontakt mit der Austrittseite des zweiten optischen Elementes und der Oberseite des zweiten Photodetektors. Der vierte optisch transparente Körper ist bevorzugt in einer die Leiterplatte von der Oberseite zur Unterseite durchdringenden Apertur, Aussparung oder Öffnung angeordnet.

Bevorzugt ist vorgesehen, dass die Leiterplatte mindestens 5, bevorzugt mindestens 7, Schichten aufweist .

Weiter bevorzugt ist vorgesehen, dass eine Wärmesenke und/oder Masse an der Unterseite der Leiterplatte angeordnet ist, dass die Wärmesenke und/oder Masse über einen von der Unterseite zu der Oberseite verlaufenden thermischen und/oder elektrischen Via mit dem Laseremitter verbunden ist.

Über den elektrischen oder thermischen Via kann die elektrische Verlustleistung des Laseremitters, welche bis zu 100 mW betragen kann, auf die Unterseite der Sensorvorrichtung bzw. der Leiterplatte abgeführt werden und dort in der Wärmesenke über eine größere Fläche verteilt werden.

Bevorzugt ist der Laseremitter, insbesondere die Laserdiode, mit der Kathodenseite auf der Oberseite der Leiterplatte befestigt, insbesondere aufgelötet. Weiter bevorzugt ist der Anodenkontakt des Laseremitters über einen Drahtbond mit der obersten Schicht der Leiterplatte verbunden.

Ferner bevorzugt sind die Kathoden des ersten und/oder zweiten Photodetektors elektrisch und thermisch an die Wärmesenke und/oder Masse angebunden.

Mit weiterem Vorteil können zwischen der Wärmesenke und der Unterseite der Leiterplatte Abstandshalter, sogenannte Spacer, vorgesehen sein.

Die Abstandshalter erhöhen die mechanische Stabilität des Aufbaus.

Mit noch weiterem Vorteil weisen mindestens fünf Schichten die stromführenden Strukturen für die Erzeugung des homogenen Magnetfelds auf.

Besonders bevorzugt weist die Leiterplatte in der Erstreckungsebene gemessen Dimensionen von 5 mm x 5 mm auf. Darüber hinaus können auf oder in der Leiterplatte die Komponenten für eine Laseremittertreiberschaltung, für eine Mikrowellentreiberschaltung und für eine Auswerteschaltung der Photodetektoren integriert sein. Diese Komponenten sind bevorzugt als ASIC-Bausteine ausgebildet.

Ganz besonders bevorzugt weist die Sensorvorrichtung ein Box-Volume von 2 cm x 2 cm x 0,5 cm auf.

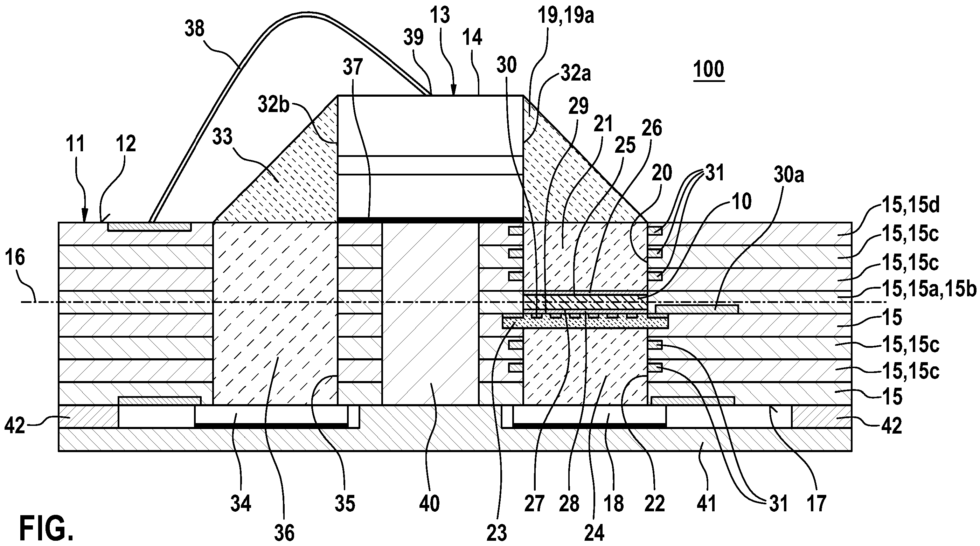

Die Erfindung wird nachstehend anhand der beigefügten Figur näher erläutert.

Die einzige Figur zeigt eine Sensorvorrichtung zur Magnetfeldmessung umfassend einen Laseremitter und einen in einer Leiterplatte angeordneten Diamanten.

Die Figur zeigt eine Sensorvorrichtung 100 zur Magnetfeldmessung mittels optischer Magnetresonanzmessung. Die Sensorvorrichtung 100 umfasst einen Diamanten 10 mit einer Vielzahl von nicht näher dargestellten Farbzentren, welche im vorliegenden Fall negativ geladene Stickstoff-Fehlstellen bzw. NV-Zentren sind. Die Sensorvorrichtung 100 umfasst ferner eine Leiterplatte 11. Auf einer Oberseite 12 der Leiterplatte 11 ist ein Laseremitter 13 angeordnet. Der Laseremitter 13 ist als Laserdiode 14 ausgebildet und emittiert grünes Licht bei einer Wellenlänge von 520 nm bis 530 nm. Die Leiterplatte 11 weist mehrere Schichten 15 auf. Die mehreren Schichten 15 umfassen eine innenliegende Schicht 15a. In der Erstreckungsebene 16 der innenliegenden Schicht 15a ist der Diamant 10 angeordnet. An einer Unterseite 17 der Leiterplatte 11 ist ein erster Photodetektor 18 angeordnet. Der Laseremitter 13 ist derart auf der Oberseite 12 der Leiterplatte 11 angeordnet, dass das Laserlicht parallel zur Oberseite 12 der Leiterplatte 11 emittiert wird. Um das von dem Laseremitter 13 emittierte Laserlicht auf den Diamanten 10 zu führen, ist an einer ersten Lichtaustrittsseite 32a des Laseremitters 13 ein als Prisma 19a ausgebildetes optisches Element 19 angeordnet, welches das Laserlicht um 90° nach unten in Richtung des Diamanten 10 in die Leiterplatte 11 umlenkt.

Zwischen dem ersten optischen Element 19 und dem Diamanten 10 ist in einer dafür in der Leiterplatte 11 vorgesehenen Öffnung 20 ein erster optisch transparenter Körper 21 angeordnet. Unterhalb des Diamanten 10 sind in einer weiteren Öffnung 22 der Leiterplatte 11 ein zweiter optisch transparenter Körper 23 und ein dritter optisch transparenter Körper 24 angeordnet, wobei der dritte optisch transparente Körper 24 unterhalb des zweiten optisch transparenten Körpers 23 angeordnet ist. Aus der ersten Lichtaustrittsseite 32a des Laseremitters 13 austretendes Laserlicht läuft durch das erste optische Element 19 und den ersten optisch transparenten Körper 21 und trifft auf den Diamanten 10, wo es die Stickstoff-Fehlstellen anregt. Vom Diamanten 10 wird anschließend rotverschobenes Fluoreszenzlicht ausgesendet, welches durch den zweiten optisch transparenten Körper 23 und durch den dritten optisch transparenten Körper 24 läuft und auf den ersten Photodetektor 18 trifft.

Der Diamant 10 weist auf einer Oberseite 25 einen Rotreflektor 26 auf, welcher dafür sorgt, dass grünes Anregungslicht nahezu vollständig transmittiert wird, während rotes Fluoresenzlicht der Stickstoff-Fehlstellen mit Wellenlängen größer als etwa 700 nm nahezu vollständig reflektiert wird. Ferner weist der Diamant 10 auf einer Unterseite 27 einen Grünreflektor 28, auf, welcher dafür sorgt, dass rotes Fluoreszenzlicht mit Wellenlängen von größer als 700 nm nahezu vollständig transmittiert wird, während grünes Anregungslicht des Laseremitters 13 nahezu vollständig reflektiert wird. Auf der Oberseite 29 des zweiten optisch transparenten Körpers 23 sind metallische Leiterbahnen 30 angeordnet. Zur Spannungsversorgung der elektrischen Leiterbahnen 30 sind auf der den zweiten optisch transparenten Körper 23 umfassenden Schicht 15b der Leiterplatte 11 Leitungen 30a vorgesehen. Durch Anlegen einer Wechselfrequenz von ca. 2,87 GHz an die Leitungen 30a kann ein Mikrowellenmagnetfeld in dem Diamanten 10 erzeugt werden, welches parallel zur Oberseite 12 der Leiterplatte 11 gerichtet ist. Ferner weisen mehrere der innenliegenden Schichten 15c stromführende Strukturen 31 auf, welche ausgebildet sind, ein senkrecht zu den Schichten 15 der Leiterplatte 11 ausgerichtetes, homogenes und den Diamanten 10 durchsetzendes Magnetfeld zu erzeugen. Die die stromführenden Strukturen 31 tragenden Schichten 15c sind dabei ober- und unterhalb der den Diamanten 10 umfassenden Schicht 15a angeordnet.

Auf der der ersten Lichtaustrittsseite 32a gegenüberliegenden zweiten Lichtaustrittsseite 32b des Laseremitters 13 ist ein zweites optisches Element 33 angeordnet, welches aus der zweiten Lichtaustrittsseite 32b austretendes Laserlicht um 90° nach unten in Richtung eines zweiten auf der Unterseite 17 der Leiterplatte 11 angeordneten Photodetektors 34 umlenkt. In einer Aussparung 35 der Leiterplatte 11 ist ein vierter optisch transparenter Körper 36 eingesetzt. Das aus dem zweiten optischen Element 33 austretende Licht durchläuft den vierten optisch transparenten Körper 36 und wird von dem zweiten Photodetektor 34 erfasst. Der vom zweiten Photodetektor 34 erfasste Laserstrahl dient als Referenzstrahl dazu, Fluktuationen in der Laserlichtleistung zu korrigieren. Der Laseremitter 13 ist mit der Kathodenseite 37 nach unten auf die Oberseite 12 der Leiterplatte 11 aufgelötet. Über einen Drahtbond 38 wird der Anodenkontakt 39 des Laseremitters 13 mit der oberen Schicht 15d der Leiterplatte 11 verbunden. Unterhalb der Kathodenseite 37 des Laseremitters 13 ist in der Leiterplatte 11 ein thermischer und elektrischer Via 40 angeordnet, welcher bis hinunter zu einer auf der Unterseite 17 der Leiterplatte 11 angeordneten Wärmesenke und Masse 41 verläuft. Über den Via 40 kann die thermische Verlustleitung des Laseremitters 13 abgeführt werden.

Die Kathoden des ersten Photodetektors 18 und des zweiten Photodetektors 34 sind elektrisch und thermisch an die Wärmesenke und die Masse 41 angebunden. Ferner sind unterhalb der Leiterplatte 11 Abstandshalter 42 vorgesehen, welche die Wärmesenke und Masse 41 auf Abstand halten und die mechanische Stabilität des Aufbaus erhöhen.

**Patentansprüche**

1. Sensorvorrichtung (100) zur Magnetfeldmessung mittels optischer Magnetresonanzmessung (ODMR), umfassend einen Diamanten (10) mit einer Vielzahl von Farbzentren, insbesondere Stickstoff-Fehlstellen, einen Laseremitter (13), einen ersten Photodetektor (18) und eine Leiterplatte (11), wobei der Laseremitter (13) zur Fluoreszenzanregung der Farbzentren in dem Diamanten (10) ausgebildet ist, wobei der erste Photodetektor (18) zum Empfangen einer Fluoreszenz-Strahlung der Farbzentren des Diamanten (10) ausgebildet ist, **dadurch gekennzeichnet, dass** die Leiterplatte (11) mehrere Schichten (15, 15a, 15b 15c, 15d) umfassend mindestens eine innenliegende Schicht (15a) aufweist, dass der Laseremitter (13) auf einer Oberseite (12) der Leiterplatte (11) angeordnet ist, dass der erste Photodetektor (18) auf einer Unterseite (17) der Leiterplatte (11) angeordnet ist, dass der Diamant (10) im Inneren der Leiterplatte (11) in der Erstreckungsebene (16) der mindestens einen innenliegenden Schicht (15a) angeordnet ist, und dass mindestens eine der Schichten (15c) stromführende Strukturen (31) aufweist, welche ausgebildet sind, ein senkrecht zu den Schichten (15, 15a, 15b 15c, 15d) der Leiterplatte (11) ausgerichtetes, homogenes und den Diamanten (10) durchsetzendes Bias-Magnetfeld zu erzeugen und wobei mindestens eine der Schichten (15b) unterhalb der den Diamanten (10) umfassenden Schicht (15a) einen zweiten optisch transparenten Körper (23) aufweist, dessen Oberseite (29) metallische Leiterbahnen (30) oder eine metallische Beschichtung aufweist, und wobei die den Diamanten (10) umfassende Schicht (15a) oder eine angrenzende Schicht Leitungen (30a) zur Spannungsversorgung der metallischen Leiterbahnen (30) aufweist, so dass durch Anlegen einer Wechselspannung an die Leitungen (30a) ein Mikrowellenmagnetfeld in dem Diamanten (10) erzeugt werden kann, welches parallel zur Oberseite (12) der Leiterplatte (11) gerichtet ist.

2. Sensorvorrichtung (100) Anspruch 1, **dadurch gekennzeichnet, dass** der Laseremitter (13) eine Laserdiode (14) ist, und/oder dass der Photodetektor (18) eine Photodiode ist.

3. Sensorvorrichtung (100) nach Anspruch 1 oder 2, **dadurch gekennzeichnet, dass** mehrere der Schichten (15c) stromführende Strukturen (31) zur Erzeugung des homogenen Bias-Magnetfeldes aufweisen, wobei die Schichten (15c) bevorzugt oberhalb und/oder unterhalb der den Diamanten (10) umfassenden innenliegenden Schicht (15a) angeordnet sind.

4. Sensorvorrichtung (100) nach einem der vorgenannten Ansprüche, **dadurch gekennzeichnet, dass** die Emissionsrichtung des Laseremitters (13) parallel zu der Oberseite (12) der Leiterplatte (11) ausgerichtet ist, und dass an einer ersten Lichtaustrittsseite (32a) des Laseremitters (13) ein erstes optisches Element (19) angeordnet ist, welches ausgebildet ist, aus der ersten Lichtaustrittseite (32a) austretendes Laserlicht, bevorzugt um 90°, umzulenken, sodass das Laserlicht auf den Diamanten (10) trifft, wobei weiter bevorzugt das erste optische Element (19) ein Spiegel oder ein Prisma (19a) ist.

5. Sensorvorrichtung (100) nach Anspruch 4, **dadurch gekennzeichnet, dass** ein zweiter Photodetektor (34) vorgesehen ist, dass der zweite Photodetektor (34) auf der Unterseite (17) der Leiterplatte (11) angeordnet ist, und dass an einer der ersten Lichtaustrittsseite (32a) des Laseremitters (13) gegenüberliegenden zweiten Lichtaustrittsseite (32b) ein zweites optisches Element (33), bevorzugt ein Spiegel oder ein Prisma, angeordnet ist, welches ausgebildet ist, aus der zweiten Lichtaustrittseite (32b) austretendes Laserlicht bevorzugt um 90°, umzulenken, sodass das Laserlicht auf den zweiten Photodetektor (34) trifft.

6. Sensorvorrichtung (100) nach Anspruch 4 oder 5, **dadurch gekennzeichnet, dass** zwischen dem ersten optischen Element (19) und dem Diamanten (10) ein erster optisch transparenter Körper (21), bevorzugt ein Glasblock, angeordnet ist, sodass von dem ersten optischen Element (19) umgelenktes Licht durch den ersten optisch transparenten Körper (21) läuft und auf den Diamanten (10) trifft.

**7.** Sensorvorrichtung (100) nach einem der vorgenannten Ansprüche, **dadurch gekennzeichnet, dass** zwischen dem zweiten optisch transparenten Körper (23) und dem ersten Photodetektor (18) ein dritter optisch transparenter Körper (24) angeordnet ist.

**8.** Sensorvorrichtung (100) nach einem der vorgenannten Ansprüche, **dadurch gekennzeichnet, dass** zwischen dem zweiten optischen Element (33) und dem zweiten Photodetektor (34) ein vierter optisch transparenter Körper (36), bevorzugt ein Glasblock, angeordnet ist.

**9.** Sensorvorrichtung (100) nach einem der vorgenannten Ansprüche, **dadurch gekennzeichnet, dass** die Leiterplatte (11) mindestens 5, bevorzugt mindestens 7, Schichten (15, 15a, 15b 15c, 15d) aufweist, und/oder dass eine Wärmesenke und/oder Masse (41) an der Unterseite (17) der Leiterplatte (11) angeordnet ist, dass die Wärmesenke und/oder Masse (41) über einen von der Unterseite (17) zu der Oberseite (12) verlaufenden thermischen und/oder elektrischen Via (40) mit dem Laseremitter (13) verbunden ist.

**Claims**

**1.** Sensor device (100) for magnetic field measurement by means of optical magnetic resonance measurement (ODMR), comprising a diamond (10) having a multiplicity of colour centres, in particular nitrogen defects, a laser emitter (13), a first photodetector (18) and a printed circuit board (11), wherein the laser emitter (13) is configured for fluorescence excitation of the colour centres in the diamond (10), wherein the first photodetector (18) is configured to receive fluorescence radiation from the colour centres of the diamond (10), **characterized in that** the printed circuit board (11) comprises a plurality of layers (15, 15a, 15b 15c, 15d) comprising at least one inner layer (15a), **in that** the laser emitter (13) is arranged on a top side (12) of the printed circuit board (11), **in that** the first photodetector (18) is arranged on a lower side (17) of the printed circuit board (11), **in that** the diamond (10) is arranged in the interior of the printed circuit board (11) in the plane of extent (16) of the at least one inner layer (15a), and **in that** at least one of the layers (15c) has current-carrying structures (31), which are configured to produce a homogeneous bias magnetic field perpendicular to the layers (15, 15a, 15b 15c, 15d) of the printed circuit board (11), which field passes through the diamond (10), and wherein at least one of the layers (15b) below the layer (15a) comprising the diamond (10) has a second optically transparent body (23), the top side (29) of which has metallic conductor tracks (30) or a metallic coating, and wherein the layer (15a) comprising the diamond (10) or an adjoining layer has lines (30a) for supplying the metallic conductor tracks (30) with power, such that, by applying AC voltage to the lines (30a), a microwave magnetic field can be generated in the diamond (10), which is directed parallel to the top side (12) of the printed circuit board (11).

**2.** Sensor device (100) according to Claim 1, **characterized in that** the laser emitter (13) is a laser diode (14), and/or **in that** the photodetector (18) is a photodiode.

**3.** Sensor device (100) according to Claim 1 or 2, **characterized in that** a plurality of the layers (15c) have current-carrying structures (31) for generating the homogeneous bias magnetic field, wherein the layers (15c) are preferably arranged above and/or below the inner layer (15a) comprising the diamond (10).

**4.** Sensor device (100) according to any one of the preceding claims, **characterized in that** the emission direction of the laser emitter (13) is aligned parallel to the top side (12) of the printed circuit board (11), and **in that** a first optical element (19) is arranged on a first light exit side (32a) of the laser emitter (13) which is configured to deflect laser light emerging from the first light exit side (32a), preferably by 90°, such that the laser light is incident on the diamond (10), wherein further preferably the first optical element (19) is a mirror or a prism (19a).

**5.** Sensor device (100) according to Claim 4, **characterized in that** a second photodetector (34) is provided, **in that** the second photodetector (34) is arranged on the lower side (17) of the printed circuit board (11), and **in that** a second optical element (33), preferably, a mirror or a prism, is arranged on a second light exit side (32b) lying opposite the first light exit side (32a) of the laser emitter (13), which second optical element is configured to deflect laser light emerging from the second light exit side (32b) preferably by 90°, such that the laser light is incident on the second photodetector (34).

**6.** Sensor device (100) according to Claim 4 or 5, **characterized in that** a first optically transparent body (21), preferably a glass block, is arranged between the first optical element (19) and the diamond (10) such that light deflected by the first optical element (19) passes through the first optically transparent body (21) and is incident on the diamond (10).

**7.** Sensor device (100) according to any one of the preceding claims, **characterized in that** a third optically transparent body (24) is arranged between the second optically transparent body (23) and the first photodetector (18).

8. Sensor device (100) according to any one of the preceding claims, **characterized in that** a fourth optically transparent body (36), preferably a glass block, is arranged between the second optical element (33) and the second photodetector (34).

9. Sensor device (100) according to any one of the preceding claims, **characterized in that** the printed circuit board (11) has at least 5, preferably at least 7, layers (15, 15a, 15b 15c, 15d) and/or **in that** a heat sink and/or ground (41) is arranged on the lower side (17) of the printed circuit board (11), **in that** the heat sink and/or ground (41) is connected to the laser emitter (13) via a thermal and/or electrical via (40) extending from the lower side (17) to the top side (12).

**Revendications**

1. Dispositif capteur (100) permettant de mesurer un champ magnétique au moyen d'une mesure par détection optique de la résonance magnétique (ODMR), comprenant un diamant (10) pourvu d'une pluralité de centres de couleur, en particulier de lacunes d'azote, un émetteur laser (13), un premier photodétecteur (18) et une carte de circuits imprimés (11), dans lequel l'émetteur laser (13) est réalisé pour l'excitation de fluorescence des centres de couleur dans le diamant (10), le premier photodétecteur (18) étant réalisé pour recevoir un rayonnement fluorescent des centres de couleur du diamant (10), **caractérisé en ce que** la carte de circuits imprimés (11) présente plusieurs couches (15, 15a, 15b, 15c, 15d) comprenant au moins une couche interne (15a), **en ce que** l'émetteur laser (13) est disposé sur une face supérieure (12) de la carte de circuits imprimés (11), **en ce que** le premier photodétecteur (18) est disposé sur une face inférieure (17) de la carte de circuits imprimés (11), **en ce que** le diamant (10) est disposé à l'intérieur de la carte de circuits imprimés (11) dans un plan d'extension (16) de ladite au moins une couche interne (15a), et **en ce qu'**au moins l'une des couches (15c) présente des structures conductrices (31) qui sont réalisées pour produire un champ magnétique de polarisation orienté perpendiculairement aux couches (15, 15a, 15b, 15c, 15d) de la carte de circuits imprimés (11), homogène, et traversant le diamant (10), et dans lequel au moins l'une des couches (15b) présente au-dessous de la couche (15a) comprenant le diamant (10) un deuxième corps optiquement transparent (23) dont la face supérieure (29) présente des pistes conductrices métalliques (30) ou un revêtement métallique, et dans lequel la couche (15a) comprenant le diamant (10) ou une couche adjacente présente des lignes (30a) pour l'alimentation en tension des pistes conductrices métalliques (30) de sorte que l'application d'une tension alternative aux lignes (30a) permet de produire un champ magnétique micro-ondes dans le diamant (10), qui est dirigé en parallèle à la face supérieure (12) de la carte de circuits imprimés (11).

2. Dispositif capteur (100) selon la revendication 1, **caractérisé en ce que** l'émetteur laser (13) est une diode laser (14), et/ou **en ce que** le photodétecteur (18) est une photodiode.

3. Dispositif capteur (100) selon la revendication 1 ou 2, **caractérisé en ce que** plusieurs des couches (15c) présentent des structures conductrices (31) pour produire le champ magnétique de polarisation homogène, les couches (15c) étant de préférence disposées au-dessus et/ou au-dessous de la couche interne (15a) comprenant le diamant (10).

4. Dispositif capteur (100) selon l'une quelconque des revendications précédentes, **caractérisé en ce que** la direction d'émission de l'émetteur laser (13) est dirigée en parallèle à la face supérieure (12) de la carte de circuits imprimés (11), et **en ce qu'**au niveau d'une première face de sortie de lumière (32a) de l'émetteur laser (13) est disposé un premier élément optique (19) qui est réalisé pour dévier, de préférence de 90°, la lumière laser sortant de la première face de sortie de lumière (32a) de sorte que la lumière laser est incidente sur le diamant (10), dans lequel de plus grande préférence, le premier élément optique (19) est un miroir ou un prisme (19a).

5. Dispositif capteur (100) selon la revendication 4, **caractérisé en ce qu'**un deuxième photodétecteur (34) est prévu, **en ce que** le deuxième photodétecteur (34) est disposé sur la face inférieure (17) de la carte de circuits imprimés (11), et **en ce qu'**au niveau d'une deuxième face de sortie de lumière (32b), opposée à la première face de sortie de lumière (32a) de l'émetteur laser (13), est disposé un deuxième élément optique (33), de préférence un miroir ou un prisme, qui est réalisé pour dévier, de préférence de 90°, la lumière laser sortant de la deuxième face de sortie de lumière (32b) de sorte que la lumière laser est incidente sur le deuxième photodétecteur (34).

6. Dispositif capteur (100) selon la revendication 4 ou 5, **caractérisé en ce qu'**entre le premier élément optique (19) et le diamant (10), un premier corps optiquement transparent (21), de préférence un bloc de verre, est disposé de sorte que la lumière déviée par le premier élément optique (19) passe à travers le premier corps optiquement transparent (21) et est incidente sur le diamant (10).

7. Dispositif capteur (100) selon l'une quelconque des revendications précédentes, **caractérisé en ce qu'**entre le deuxième corps optiquement transparent (23) et le premier photodétecteur (18) est disposé un troisième corps optiquement transparent (24).

8. Dispositif capteur (100) selon l'une quelconque des revendications précédentes, **caractérisé en ce qu'**entre le deuxième élément optique (33) et le deuxième photodétecteur (34) est disposé un quatrième corps optiquement transparent (36), de préférence un bloc de verre.

9. Dispositif capteur (100) selon l'une quelconque des revendications précédentes, **caractérisé en ce que** la carte de circuits imprimés (11) présente au moins 5, de préférence au moins 7 couches (15, 15a, 15b, 15c, 15d), et/ou **en ce qu'**un dissipateur thermique et/ou une masse (41) sont disposés sur la face inférieure (17) de la carte de circuits imprimés (11), **en ce que** le dissipateur thermique et/ou la masse (41) sont reliés à l'émetteur laser (13) par un trou d'interconnexion (40) thermique et/ou électrique s'étendant de la face inférieure (17) à la face supérieure (12).

FIG.

EP 4 314 788 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102018214617 A1

**In der Beschreibung aufgeführte Nicht-Patentliteratur**

- **STÜRNER, FELIX M. et al.** Compact integrated magnetometer based on nitrogen-vacancy centres in diamond. *Diamond and Related Materials*, 17 January 2019, vol. 93, 59-65

- **STÜRNER FELIX M. et al.** Integrated and Portable Magnetometer Based on Nitrogen-Vacancy Ensembles in Diamond. *Advanced Quantum Technilogies*, 10 February 2021, vol. 4 (4), 2000111